# EUROPÄISCHE PATENTSCHRIFT

(11) **EP 0 555 667 B1**
(45) Veröffentlichungstag und Bekanntmachung des Hinweises auf die Patenterteilung: **17.04.1996**
(21) Anmeldenummer: 93100861.9
(22) Anmeldetag: 21.01.1993
(51) Int. Cl.: B41F 15/18

(54) **Verfahren und Vorrichtung zum Siebdrucken**
Method and apparatus for screen printing
Procédé et dispositif d'impression sérigraphique

(30) Priorität: 14.02.1992 DE 4204392
(43) Veröffentlichungstag der Anmeldung: 18.08.1993
(73) Patentinhaber: Rheinmetall Industrie GmbH, D-40880 Ratingen (DE)
(72) Erfinder: Graener, Rudolf, Dr., W-4006 Erkrath (DE); von der Lippe, Norbert, W-4130 Moers (DE); Sommer, Peter, W-4100 Duisburg 29 (DE)

(56) Entgegenhaltungen:
- WO-A-86/04287
- WO-A-86/04850
- DE-A- 3 823 853

## Beschreibung

Die Erfindung betrifft ein Verfahren und eine Vorrichtung zum Siebdrucken von gewölbten Stahlhybridplatten geringer Dicke.

Die Herstellung von Leiterkarten aus Stahlhybridplatten, d.h. aus einem plattenförmigen Stahlsubstrat beschichtet mit einem elektrisch isolierenden, anorganischen Material wie Glas, Keramik, Email oder Glaskeramik ist an sich bekannt. Hierbei werden Stahlplatten einer Stärke von ca. 0,5 bis 6 mm verwendet.

Beim Einbrennen der isolierenden Beschichtung(en) passiert es häufig, daß sich die dünnen Leiterkarten durchbiegen. Zwar kann dem durch dickeres Material entgegengewirkt werden, jedoch ist letzteres zumindest für Leiterkarten wegen der erhöhten Kosten und des Gewichts im allgemeinen unerwünscht. Außerdem ist dickeres Blech beim Brennprozeß problematisch.

Außerdem kann man gewölbte Platten mittels Tampondruck, d.h. mittels eines gewölbten Stempels bedrucken, jedoch ist dies nicht immer genügend präzise, da der Tampondruck nur Schichtdicken bis zu 10 µm ermöglicht, während man beim Siebdruck wesentlich größere Dicken erreicht. So werden auf Leiterkarten häufig Leiterbahnen mit einer Breite in der Größenordnung von 50 µm gedruckt, so daß bei gewölbten Platten Genauigkeitsprobleme hinsichtlich der Konturen und der Leiterbahnstärke entstehen, da das Drucksieb und die Filme zur Herstellung der Drucksiebe plan sind.

Aus der DE 38 23 853 A1 ist bereits eine Vorrichtung zum Siebdrucken von Werkstücken in Form von Scheiben oder Platten bekannt. Dabei werden die Werkstücke auf einer Auflage plaziert, die eine an die Werkstücke angepaßte veränderbare Aufnahme aufweist. Die Aufnahme besteht im wesentlichen aus mehreren metallischen Anschlagleisten, die in ihrer jeweiligen Lage durch eine Vielzahl von Elektromagneten definiert positionierbar sind.

Aufgabe der Erfindung ist es daher, ein Verfahren und eine Vorrichtung der eingangserwähnten Art zu schaffen, mit denen eine sehr hohe Druckgenauigkeit auch bei gewölbten Platten erzielbar ist.

Diese Aufgabe wird entsprechend den Merkmalen der Ansprüche 1 und 2 gelöst.

Weitere Ausgestaltungen der Erfindung sind der nachfolgenden Beschreibung und den abhängigen Ansprüchen zu entnehmen.

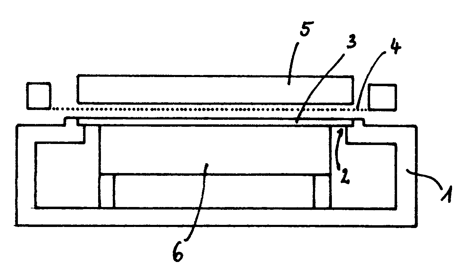

Die Erfindung wird nachstehend anhand des in der beigefügten Abbildung dargestellten Ausführungsbeispiels, das schematisch eine Siebdruckvorrichtung zeigt, näher erläutert.

Die Siebdruckvorrichtung umfaßt eine Aufnahme 1 mit einem Siebdrucknest 2 für eine Leiterkarte 3 in Form einer dünnen Stahlhybridplatte. Über der Aufnahme 1 ist ein Sieb 4 und ein Druckrakel 5 zum Drucken von Leiterbahnen etwa aus einer Metall-, beispielsweise einer Silberlegierung auf die Leiterkarte 3 angeordnet.

Unter dem Siebdrucknest 2 ist in der Aufnahme 1 ein Magnet 6, beispielsweise ein Elektromagnet, angeordnet, der stark genug ist, um eine flachgedrückte Leiterkarte 3 plan zu halten.

Zum Bedrucken einer Leiterkarte 3 wird diese in dem Siebdrucknest 2 plaziert. Die Fixierung der Leiterkarte 3 in der Ebene des Siebdrucknestes 2 erfolgt über Anlegen an Ecken oder speziellen Ausnehmungen. Nach dem Plazieren der Leiterkarte 3 wird der Elektromagnet 6 aktiviert.

Wenn sich die Leiterkarte 3 beim Einbrennen von Keramikschichten o.dgl. gewölbt hat, wird sie flachgedrückt. Der Elektromagnet 6 hält die Leiterkarte 3 während des Bedruckens plan, so daß mit planen Sieb 4 auf eine plane Fläche gedruckt wird. Hierdurch wird die Leiterkarte 3 ganzflächig auf das Siebdrucknest 2 gezogen. Insbesondere kann die Leiterkarte 3 praktisch ohne Luftspalt auf dem Elektromagneten 6 gehalten werden.

Durch den Elektromagneten 6 wird in sehr einfacher Weise daher die Durchwölbung der Leiterkarte 3 kompensiert, so daß sich eine sehr hohe Druckgenauigkeit ergibt, die sich auch zum Aufdrucken von Leiterbahnen mit einer Breite in der Größenordnung von 50 µm oder weniger eignet. Die sich ergebende Schichtdicke der Leiterbahnen ist außerdem gleichbleibend.

Für kleine Leiterkarten 3 kann es zweckmäßig sein, den Elektromagneten 6 durch einen Permanentmagneten zu ersetzen. Um ein Freigeben der Leiterkarte 3 nach dem Drucken zu erleichtern, kann der Permanentmagnet mit verschiebbaren Polschuhen versehen sein.

Außerdem läßt sich hierdurch die Stärke des für die Leiterkarte 3 verwendeten Stahlblechs verringern.

## Patentansprüche

1. Verfahren zum Siebdrucken gewölbter Stahlhybridplatten geringer Dicke, welches die folgenden Verfahrensschritte enthält:
a) Einlegen der jeweiligen Stahlhybridplatte (3) in ein Siebdrucknest (2) einer Siebdruckvorrichtung;
b) Flachdrücken der jeweiligen in dem Siebdrucknest (2) angeordneten Stahlhybridplatte (3) mit Hilfe eines unterhalb der Stahlhybridplatte (3) angeordneten Magneten (6) und
c) Durchführung des Siebdruckes, wobei die Stahlhybridplatte (3) während des Druckvorganges durch den Magneten (6) in flach gedrücktem Zustand gehalten wird.

2. Vorrichtung zum Siebdrucken gewölbter Stahlhybridplatten (3) geringer Dicke, wobei die Vorrichtung
a) eine mit einem Siebdrucknest (2) versehene Aufnahme (1) für die Stahlhybridplatten (3) aufweist und
b) einen Magneten (6) enthält, der unterhalb des Siebdrucknestes (2) angeordnet ist und dessen Stärke ausreicht, um die jeweilige Stahlhybridplatte (3) beim Bedrucken im flachgedrückten Zustand zu halten.

3. Vorrichtung nach Anspruch 2, dadurch gekennzeichnet, daß der Magnet (6) ein Elektromagnet ist.

4. Vorrichtung nach Anspruch 2, dadurch gekennzeichnet, daß der Magnet (6) ein Permanentmagnet mit verschiebbaren Polschuhen ist.

## Claims

1. Process for screen printing of cambered steel hybrid plates of small thickness, comprising the following steps in the process:
(a) Insertion of the relevant steel hybrid plate (3) in a screen printing bed (2) of a screen printing device;
(b) pulling the steel hybrid plate (3) in the screen printing bed (2) flat using a magnet (6) positioned underneath the steel hybrid plate (3); and
(c) carrying out the screen printing operation during which printing process the steel hybrid plate (3) is held by the magnet (6) in the pulled flat state.

2. Device for screen printing of cambered steel hybrid plates (3) of small thickness, wherein the device
(a) has a receiver (1) provided with a screen printing bed (2), for the steel hybrid plates, and
(b) containing a magnet (6) which is positioned underneath the screen printing bed (2) and of which the thickness is sufficient to keep the relevant steel hybrid plate (3) in a pulled flat state while being printed.

3. Device in accordance with Claim 2, characterised in that the magnet (6) is an electromagnet.

4. Device in accordance with Claim 2, characterised in that the magnet (6) is a permanent magnet with sliding pole shoes.

## Revendications

1. Procédé d'impression sérigraphique de plaques en acier hybride bombées de faible épaisseur, qui comprend les étapes suivantes:
a) la mise en place de la plaque en acier hybride (3) dans une cavité d'impression sérigraphique (2) d'un dispositif d'impression sérigraphique;
b) la compression à plat de la plaque en acier hybride (3) disposée dans la cavité d'impression sérigraphique (2) à l'aide d'un aimant (6) disposé au-dessous de la plaque en acier hybride (3), et
c) la réalisation de l'impression sérigraphique, la plaque en acier hybride (3) étant maintenue à plat à l'état pressé au moyen de l'aimant (6) pendant le processus d'impression.

2. Dispositif d'impression sérigraphique de plaques en acier hybride bombées (3) de faible épaisseur, dans lequel le dispositif comprend
a) un logement (1) muni d'une cavité d'impression sérigraphique (2) pour les plaques en acier hybride (3), et
b) un aimant (6) qui est disposé au-dessous de la cavité d'impression sérigraphique (2) et dont la force est suffisante pour maintenir la plaque en acier hybride (3) à l'état pressé à plat pendant l'impression.

3. Dispositif selon la revendication 2, caractérisé en ce que l'aimant (6) est un électroaimant.

4. Dispositif selon la revendication 2, caractérisé en ce que l'aimant (6) est un aimant permanent à pièces polaires mobiles.
